# EUROPEAN PATENT SPECIFICATION

(11) **EP 4 033 106 B1**
(45) Date of publication and mention of the grant of the patent: **11.11.2026**
(21) Application number: 20877801.9
(22) Date of filing: 30.09.2020
(51) Int. Cl.: F04D 29/00, H05K 7/20

(54) **SLAT FOR BACKFLOW PREVENTION, BACKFLOW PREVENTION APPARATUS, AND ELECTRONIC DEVICE**
LAMELLE ZUR RÜCKFLUSSVERHINDERUNG, RÜCKFLUSSVERHINDERUNGSVORRICHTUNG UND ELEKTRONISCHE VORRICHTUNG
LAMELLE POUR PRÉVENTION DE REFLUX, APPAREIL DE PRÉVENTION DE REFLUX ET DISPOSITIF ÉLECTRONIQUE

(30) Priority: 14.10.2019 CN 201921717638 U
(43) Date of publication of application: 27.07.2022
(73) Proprietor: ZTE Corporation, Shenzhen, Guangdong 518057 (CN)
(72) Inventor: YANG, Bo, Shenzhen, Guangdong 518057 (CN); JI, Shengtao, Shenzhen, Guangdong 518057 (CN); YE, Chenlei, Shenzhen, Guangdong 518057 (CN); TAO, Shuhua, Shenzhen, Guangdong 518057 (CN)
(74) Representative: WBH Wachenhausen Patentanwälte PartG mbB
(86) International application number: PCT/CN2020/119431
(87) International publication number: WO 2021/073437

(56) References cited:
- CN-A- 103 161 769
- CN-U- 202 251 015
- CN-U- 203 394 829
- CN-U- 210 829 860
- CN-Y- 201 144 844
- JP-A- 2003 130 439
- US-A- 5 277 658
- US-A1- 2004 129 410
- US-A1- 2005 016 595
- US-A1- 2011 259 550
- US-A1- 2012 145 257

## Description

### TECHNICAL FIELD

The present disclosure relates to the field of electronic devices and, in particular, to a slat for backflow prevention, a backflow prevention apparatus, and an electronic device.

### BACKGROUND

As the power consumption of various electronic devices increases, especially for indoor plug-box products, heat dissipation units such as fans are required to cool the devices. That is, the fan brings cold air into an interior of the device and take the heat generated in the interior of the device out of the interior of the device through heat exchange. When a fan in a device stops working due to malfunction, according to the second law of thermodynamics, the highpressure and high-heat gas brought out by other fans will flow to the low-temperature and low-pressure area corresponding to the stopped fan, generating backflow at the stopped fan which causes the hot air forced out by the fans to flow back into the device, thus directly affecting the heat dissipation performance of the device or damaging components inside the device. Therefore, electronic devices need to be equipped with backflow prevention apparatuses.

In some cases, backflow prevention apparatuses are often used in conjunction with fans. That is, when a fan is damaged, the backflow prevention apparatus is driven by means of a motor, a magnetic force, a mechanical force, gravity, etc., so as to realize the opening and closing of the air outlet, where the use of the motor, magnetic force, mechanical force, etc., as the driving force of the backflow prevention apparatus will increase the complexity of the devices and will cause long-term power loss. When using gravity to drive backflow prevention apparatuses, louvered backflow prevention apparatuses are usually used. Although the use of gravity to drive a backflow prevention apparatus does not increase the complexity of the devices, the self-weight of the slats in the backflow prevention apparatus affects the rotation tendency of the slat, making it problematic for the backflow prevention apparatus to accurately open or close the air outlet in different situations accordingly.

In US 2011/259550 A1, plural flaps provided in a wind-pressure shutter are located approximately parallel to a direction of an airflow path, i.e., the airflow path is opened. Thus, the wind-pressure loss of cooling wind passing through the shutter can be reduced to near zero during the normal operation of the fan. If an air-backflow flows from the exhaust vent due to a fan failure, the flap slightly inclined toward the airflow path receives wind pressure of the air-backflow on its surface, thereby swings about the support shaft to close the airflow path.

In US 2004/129410 A1, a back-flow preventing valve offering low resistance to fluid flow through the valve in an open position thereof and yet enabling secure closing of the valve is provided. The reduced resistance to flow is achieved by arranging vanes of the valve so that in the open position they are essentially balanced with regard to the force of gravity and do not significantly impede the airflow, neither with regard to the pressure drop caused by the valve nor with regard to an undesirable deflection of the airflow. Leaving the open position the vanes are increasingly urged towards their closed position by the force of gravity. Specifically, this is accomplished by inclining the pivot axes of the vanes against the general direction of flow through the valve.

In JP 2003 130439 A, a fan device with the back-flow prevention mechanism has a shutter which closes an entire air passage when stopped and which when actuated is opened only in one direction by the wind pressure of a fan. The shutter consists of a plurality of flaps arranged in the form of an arc, with the flaps having about equal masses in front of and behind a pivot. The plurality of flaps arranged in the form of an arc to form the shutter are each preferably journaled by a radial pivot and formed to have a curved surface facing in the same direction and having an edge line approximately parallel to the pivot. Alternatively, each of the flaps is formed to increase in thickness from the front to back of the pivot, or the side of each flap with a smaller projected area behind the pivot has a weight added for adjusting its mass. A mounting member retaining the plurality of flaps has a stopper for keeping the angle of the opening movement of each flap at about 90 degrees.

In US 5 277 658 A, barometric damper apparatus includes a plurality of louvers or damper blades pivotly secured to a frame and which pivot to the closed position under gravity when air stops flowing. Each louver includes a relatively short upstream portion and a relatively long downstream portion, with the relatively short upstream portion including a counterweight which causes the relatively short upstream portion to be heavier than the relatively long downstream portion so that the louver apparatus pivots to the closed position with the relatively short upstream portion always moving downwardly. A bend in the relatively long downstream portion allows the louver to contact the adjacent louver in the closed position so as to provide a seal to prevent air from leaking back through the damper apparatus.

### SUMMARY

The features of the slat for backflow prevention according to embodiments of the present disclosure are set out in the appended set of claims.

### BRIEF DESCRIPTION OF DRAWINGS

Fig. 1 is a schematic diagram of an embodiment of a slat for backflow prevention provided in embodiments of the present disclosure;
Fig. 2 is a cross-sectional diagram along the A-B direction of an embodiment of the slat for backflow prevention provided in embodiments of the present disclosure (Embodiment I);
Fig. 3 is a cross-sectional diagram along the A-B direction of an embodiment of the slat for backflow prevention provided in embodiments of the present disclosure (Embodiment II);
Fig. 4 is a schematic diagram of an embodiment of a backflow prevention apparatus provided in embodiments of the present disclosure;
Fig. 5 is a schematic diagram (open state) of an embodiment of the backflow prevention apparatus provided in embodiments of the present disclosure;
Fig. 6 is a schematic diagram (closed state) of an embodiment of the backflow prevention apparatus provided in embodiments of the present disclosure;
Fig. 7 is one of partial schematic diagrams of slats and an outer frame in the backflow prevention apparatus provided in embodiments of the present disclosure (for the situation where the working wind flows from top to bottom);
Fig. 8 is a second one of the partial schematic diagrams of the slats and the outer frame in the backflow prevention apparatus provided in embodiments of the present disclosure (for the situation of a horizontal air duct); and
Fig. 9 is a schematic diagram of an embodiment of an electronic device provided in embodiments of the present disclosure.

### DETAILED DESCRIPTION

In order to make the purpose, technical schemes and advantages of the present disclosure clear, embodiments of the present disclosure will be described in further detail below in conjunction with the accompanying drawings, and it is obvious that the described embodiments are only some of the embodiments of the present disclosure, and not all of them. All other embodiments obtained by those having ordinary skill in the art based on the embodiments of the present disclosure without inventive effort are within the scope of the present disclosure.

The shape and size of the parts in the accompanying drawings do not reflect the true scale and are intended only to facilitate understanding of the contents of the embodiments of the present disclosure.

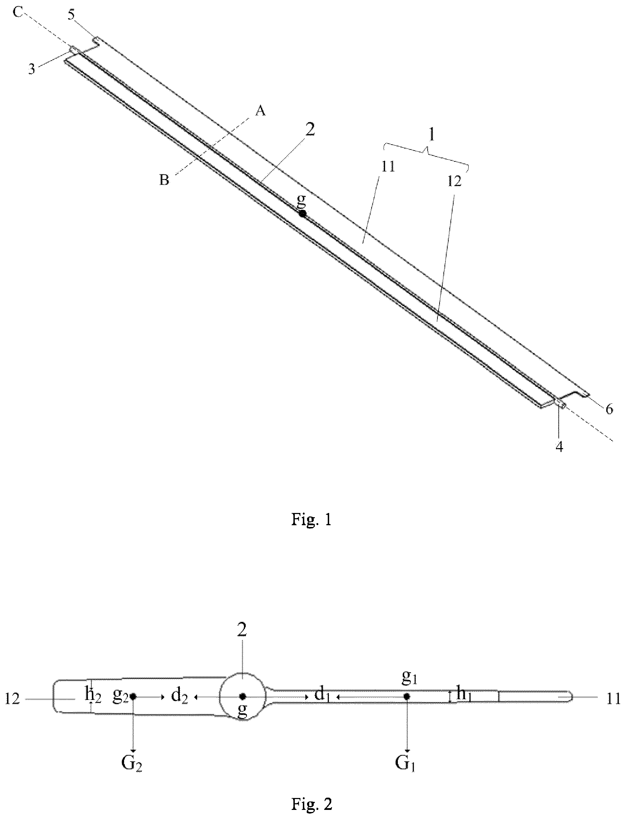

As shown in Fig. 1, an embodiment provides a slat for backflow prevention, including a body 1 and a rotating shaft 2.

The slat 2 is connected in a lengthwise direction of the body 1, and divides the body 1 into a first sub-slat 11 and a second sub-slat 12. The body 1 is a planar structure, and thus the first sub-slat 11 and the second sub-slat 12 are also two planar structures, where the first sub-slat 11 and the second sub-slat 12 extend in directions facing away from the rotating shaft, and the extension direction of the first sub-slat 11 is opposite to that of the second sub-slat 12. The body 1 is rotatable about the rotating shaft 2 and the body 1 has a center-of-gravity region located on the rotating shaft 2. The center-of-gravity region of the body 1 is the region obtained by drawing a circle with a center of gravity g of the body 1 as the origin, that is, the center of gravity g of the body 1 is the center of the center-of-gravity region. The radius of the center-of-gravity region should not be too large, for example, the center-of-gravity region of the body 1 is a circular region of which the origin is the center of gravity g of the body 1 and the radius is 3 mm. The smaller the radius of the center-of-gravity region, the easier it is to maintain the position of the center of gravity of the body 1 during the rotation of the body 1 about the rotating shaft 2. In addition, the difference between the magnitude of the gravitational moment of the first sub-slat 11 and the magnitude of the gravitational moment of the second sub-slat 12 does not exceed a preset value. This preset value should not be too large, for example, it may be 0.1 Nm, and the smaller the preset value, the easier it is to eliminate the effect of gravity on rotation during the rotation of the body 1 about the rotating shaft 2.

In the invention, according to the above explanation, under the optimal conditions, in order to keep the position of the center of gravity g of the body 1 constant during rotation, the center of gravity g of the body 1 is located on the rotating shaft 2 and on a center line of the rotating shaft 2. Under the optimal conditions, if the body 1 and the rotating shaft 2 are in a structure of which the mass is uniform and the shape is symmetric about the center of gravity g of the body, the center of gravity g of the body 1 coincides with a midpoint of the center line of the rotating shaft 2.

In an implementation, according to the above explanation, under the optimal conditions, in order for the body 1 to maintain self-balance during rotation, the magnitude of the gravitational moment of the first sub-slat 11 is equal to the magnitude of the gravitational moment of the second sub-slat 12, so that the gravitational moment of the first sub-slat 11 can cancel out the gravitational moment of the second sub-slat 12 during the rotation of the body 1 about the rotating shaft 2, thereby eliminating the effect of gravity on rotation.

Hereinafter, an illustration will be provided taking the example in which the center of gravity g of the body 1 is located on the rotating shaft and the magnitude of the gravitational moment of the first sub-slat 11 is equal to the magnitude of the gravitational moment of the second sub-slat 12.

It should be noted that the gravitational moment of the first sub-slat 11 is the tendency of rotation of the first sub-slat 11 about the rotating shaft 2 under the driving of gravity, and the gravitational moment of the second sub-slat 12 is the tendency of rotation of the second sub-slat 12 about the rotating shaft 2 under the driving of gravity.

It should be noted that the rotating shaft 2 is connected in the lengthwise direction of the body 1 and the body 1 is rotatable about the rotating shaft 2, that is, the rotating shaft 2 is rotationally connected to the body 1. The extension line of the center line of the rotating shaft 2 is the rotating center line C of the body, the body 1 is rotatable about the rotating center line C, and the center of gravity g of the body 1 is located on the center line (rotating center line C) of the rotating shaft. The specific location of the center of gravity g on the rotating shaft 2 is determined based on the structure and mass distribution of the body 1, which is not limited herein.

It should be noted that the lengthwise direction of the body 1 is the extension direction of the body 1, and the rotating shaft 2 runs through the body 1 along the lengthwise direction of the body 1 and is rotationally connected to the body 1.

With respect to the above slat for backflow prevention provided in this embodiment, in the application of the slat in a backflow prevention apparatus, a plurality of such slats are installed in the backflow prevention apparatus, in which case the slats rotate to a corresponding position to control the air outlet to open so that the hot air (hereinafter referred to as "working wind") in the interior of the device can flow out from the air outlet, or the slats rotate to a corresponding position to control the air outlet to close so as to block the flow of backflow wind from the air outlet back to the interior of the device. Since the center-of-gravity region of the body 1 in the slat is on the rotating shaft 2, the position of the center of gravity g can be kept constant during the rotation of the slat about the rotating shaft 2, thus maintaining the stability of rotation. Further, since the magnitudes of the gravitational moments of the first sub-slat 11 and the second sub-slat 12 are approximately equal (or equal) while the extension direction of the first sub-slat 11 is opposite to that of the second sub-slat 12, that is, the gravitational moment of the first sub-slat 11 is in an opposite direction to the gravitational moment of the second sub-slat 12, during the rotation of the slat about the rotating shaft 2, under the premise that the center of gravity g of the slat is kept in a fixed position, the gravitational moment of the first sub-slat 11 can cancel out the gravitational moment of the second sub-slat, so that the slat can maintain self-balance. Therefore, it is possible to avoid the effect of the gravity of the slat during its rotation, thus causing the slat to rotate only under the driving of wind (such as working wind or backflow wind), and thus ensuring that the slat can accurately rotate to the position of opening or closing the air outlet in the corresponding situation.

In the invention, as shown in Fig. 1, in the above slat for backflow prevention provided in this embodiment, in the body 1, an area of the first sub-slat 11 is larger than that of the second sub-slat 12, so that when the working wind or backflow wind blows on the slat, because the load area of the first sub-slat 11 is larger than that of the second sub-slat 12, the thrust force generated by the wind on the surface of the first sub-slat 11 is larger than the thrust force generated by the wind on the surface of the second sub-slat 12, and thus the body 1 can be driven to rotate about the rotating shaft 2 under the action of the difference between the thrust forces. Further, the greater the area difference between the area of the first sub-slat 11 and the area of the second sub-slat 12, the greater the difference between the thrust forces of the two sub-slats under the action of the working wind or backflow wind, that is, the more easily the slat is driven by the working wind or backflow wind. Also, since the gravitational moments of the first sub-slat 11 and the second sub-slat 12 may cancel each other out, only a small amount of wind power is required to drive the slat, allowing the slat to be driven more accurately by the backflow wind or working wind to rotate to the corresponding position. Since the area of the first sub-slat 11 is larger than that of the second sub-slat 12, the mass of the first sub-slat 11 can be made smaller or equal to that of the second sub-slat 12 depending on the structure of the slat. In addition, to make the magnitude of the gravitational moment of the first sub-slat 11 approximately equal (or equal) to the magnitude of the gravitational moment of the second sub-slat 12, in the case where the force arm of the center of gravity of the first sub-slat 11 from the center of gravity g of the body 1 is approximately equal (or equal) to the force arm of the center of gravity of the second sub-slat 12 from the center of gravity g of the body 1, it is necessary to make the mass of the first sub-slat 11 approximately equal (or equal) to that of the second sub-slat 12; and in the case where the force arm of the center of gravity of the first sub-slat 11 from the center of gravity g of the body 1 is greater than the force arm of the center of gravity of the second sub-slat 12 from the center of gravity g of the body 1, it is necessary to make the mass of the first sub-slat 11 smaller than that of the second sub-slat 12. Hereinafter, an illustration will be provided taking the example in which the mass of the first sub-slat 11 is less than that of the second sub-slat 12.

### Embodiment I.

As shown in Figs. 1 and 2, Fig. 2 illustrates an embodiment of a cross-sectional diagram of the slat in Fig. 1 cut along the A-B direction. The slat 2 is connected in the lengthwise direction of the body 1, and divides the body 1 into a first sub-slat 11 and a second sub-slat 12. In a direction perpendicular to the rotating shaft 2, a width of the first sub-slat 11 is greater than that of the second sub-slat 12, while a length of the first sub-slat 11 is almost equal to that of the second sub-slat 12, so that the area of the first sub-slat 11 is greater than that of the second sub-slat 12.

Referring to Fig. 2, as can be seen from the fact that the width of the first sub-slat 11 is greater than that of the second sub-slat 12, the distance from the center of gravity g₁ of the first sub-slat 11 to the center of gravity g of the body 1 is the force arm d₁ of the first sub-slat 11, and the gravity on the first sub-slat 11 is G₁, then the gravitational moment of the first sub-slat 11 is M₁ = G₁ × d₁; and the distance from the center of gravity g₂ of the second sub-slat 12 to the center of gravity g of the body 1 is the force arm d₂ of the second sub-slat 12, and the gravity on the second sub-slat 12 is G₂, then the gravitational moment of the second sub-slat 12 is M₂ = G₂ × d₂. Since d₁ > d₂, to make the difference between M₁ and M₂ not exceed a preset value, it is required that G₁ < G₂. Therefore, the thickness h₁ of the first sub-slat 11 may be made smaller than the thickness h₂ of the second sub-slat 12, so that the mass of the first sub-slat 11 can be reduced. The difference in mass between the first sub-slat 11 and the second sub-slat 12 may be calculated based on the difference in area between the two, so that G1 and G2 can be determined to make the difference between the magnitude of the gravitational moment M₁ of the first sub-slat 11 and the magnitude of the gravitational moment M₂ of the second sub-slat 12 not exceed the preset value. Since the magnitudes of the gravitational moment M₁ of the first sub-slat 11 and the gravitational moment M₂ of the second sub-slat 12 are approximately equal (or equal) and in opposite directions, the gravitational moments of the two can cancel each other out, so that during the rotation of the slat about the rotating shaft 2, under the premise that the center of gravity g of the body 1 is kept in a fixed position, it is possible to avoid the effect of the gravity of the slat during its rotation, thus causing the slat to rotate only under the driving of wind (such as working wind or backflow wind), and thus ensuring that the slat can accurately rotate to the position of opening or closing the air outlet in the corresponding situation.

### Embodiment II.

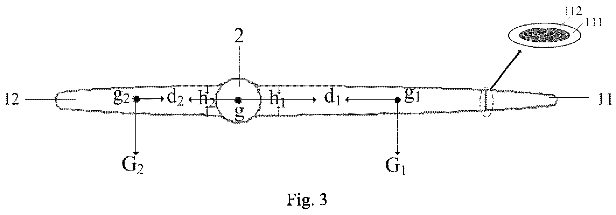

As shown in Figs. 1 and 3, Fig. 3 illustrates an embodiment of a cross-sectional diagram of the slat in Fig. 1 cut along the A-B direction. The slat 2 is connected in the lengthwise direction of the body 1, and divides the body 1 into a first sub-slat 11 and a second sub-slat 12. In a direction perpendicular to the rotating shaft 2, the width of the first sub-slat 11 is greater than that of the second sub-slat, while the length of the first sub-slat 11 is almost equal to that of the second sub-slat 12, so that the area of the first sub-slat 11 is greater than that of the second sub-slat 12.

Referring to Fig. 3, the analysis process is the same as that in Embodiment I. To make the magnitude of the gravitational moment M₁ of the first sub-slat 11 equal to the magnitude of the gravitational moment M₂ of the second sub-slat 12, it is required that G₁ < G₂. Therefore, the interior of the first sub-slat 11 may be made hollow, that is, the cut surface of the first sub-slat 11 (as shown in the upper right part of Fig. 3) may be divided into an outer shell 111 and the hollow portion 112, so that the mass of the first sub-slat 11 can be reduced. Further, by controlling the magnitude of the reduced mass of the first sub-slat 11, it is possible to make the thickness h₁ of the first sub-slat 11 approximately equal (or equal) to the thickness h₂ of the second sub-slat 12, or, of course, it is also possible to make the thickness h₁ of the first sub-slat 11 greater than the thickness h₂ of the second sub-slat 12, which is not limited herein. The difference in mass between the first sub-slat 11 and the second sub-slat 12 may be calculated based on the difference in area between the two, so that G1 and G2 can be determined to make the difference between the magnitude of the gravitational moment M₁ of the first sub-slat 11 and the magnitude of the gravitational moment M₂ of the second sub-slat 12 not exceed the preset value. Since the magnitudes of the gravitational moment M₁ of the first sub-slat 11 and the gravitational moment M₂ of the second sub-slat 12 are approximately equal (or equal) and in opposite directions, the gravitational moments of the two can cancel each other out, so that during the rotation of the slat about the rotating shaft 2, under the premise that the center of gravity g of the body 1 is kept in a fixed position, it is possible to avoid the effect of the gravity of the slat during its rotation, thus causing the slat to rotate only under the driving of wind (such as working wind or backflow wind), and thus ensuring that the slat can accurately rotate to the position of opening or closing the air outlet in the corresponding situation.

### Embodiment III.

The slat 2 is connected in the lengthwise direction of the body 1, and divides the body 1 into a first sub-slat 11 and a second sub-slat 12. In a direction perpendicular to the rotating shaft 2, the width of the first sub-slat 11 is greater than that of the second sub-slat, while the length of the first sub-slat 11 is almost equal to that of the second sub-slat 12, so that the area of the first sub-slat 11 is greater than that of the second sub-slat 12.

The analysis process is the same as that in Embodiment I. To make the magnitude of the gravitational moment M₁ of the first sub-slat 11 equal to the magnitude of the gravitational moment M₂ of the second sub-slat 12, it is required that G₁ < G₂. Therefore, it is possible to make the unit mass of the material of the first sub-slat 11 smaller than the unit mass of the material of the second sub-slat 12, so that in the case where the thickness of the first sub-slat 11 is approximately equal (or equal) to the thickness of the second sub-slat 12, the mass of the first sub-slat 11 can be reduced so that the difference between the magnitude of the gravitational moment M₁ of the first sub-slat 11 and the magnitude of the gravitational moment M₂ of the second sub-slat 12 does not exceed a preset value. Of course, by adjusting the unit mass of the material of the first sub-slat 11 and the unit mass of the material of the second sub-slat 12, the thickness of the first sub-slat 11 may also be greater than (or equal to) the thickness of the second sub-slat 12, which is not limited herein. Since the magnitudes of the gravitational moment M₁ of the first sub-slat 11 and the gravitational moment M₂ of the second sub-slat 12 are equal and in opposite directions, the gravitational moments of the two can cancel each other out, so that during the rotation of the slat about the rotating shaft 2, under the premise that the center of gravity g of the body 1 is kept in a fixed position, it is possible to avoid the effect of the gravity of the slat during its rotation, thus causing the slat to rotate only under the driving of wind (such as working wind or backflow wind), and thus ensuring that the slat can accurately rotate to the position of opening or closing the air outlet in the corresponding situation.

As can be seen from the above, the thickness of the first sub-slat 11 and the thickness of the second sub-slat 12 may be in a variety of forms, and by adjusting the structure or material of the first sub-slat 11 and the second sub-slat 12, it is possible to make the thickness of the first sub-slat 11 equal to that of the second sub-slat 12, or make the thickness of the first sub-slat 11 less than that of the second sub-slat 12, and it is also possible to make the thickness of the first sub-slat 11 greater than that of the second sub-slat 12, and the specifics may be designed as needed, which is not limited herein.

It should be noted that the above Embodiment I, Embodiment II, and Embodiment III are only several implementations of the slat for backflow prevention provided in this embodiment, and the slat for backflow prevention provided in this embodiment may also have more structures, which is not limited herein.

It should be noted that in the above slat for backflow prevention provided in this embodiment, the first sub-slat 11 and the second sub-slat 12 and the rotating shaft 2 may be integral or spliced, i.e., composed of several parts, and the specifics may be designed as needed, which is not limited herein.

In an implementation, as shown in Fig. 1, in the above slat for backflow prevention provided in this embodiment, the rotating shaft 2 is provided with a first rotating shaft head 3 and a second rotating shaft head 4 at two ends, respectively. In the application of the slat provided in this embodiment to a backflow prevention apparatus, the first rotating shaft head 3 and the second rotating shaft head 4 are used to fit with the connection portions on the outer frame of the backflow prevention apparatus to connect the slat to the outer shell. The specific shape and size of the first rotating shaft head 3 and the second rotating shaft head 4 may be designed as needed, which is not limited herein.

In an implementation, as shown in Fig. 1, in the above slat for backflow prevention provided in this embodiment, the first sub-slat 11 is provided with a first limit structure 5 and a second limit structure 6 at two ends of an outer side facing away from the rotating shaft 2, respectively. In the application of the slat provided in this embodiment to a backflow prevention apparatus, the first limit structure 5 and the second limit structure 6 are used to fit with rotation grooves on the outer frame of the backflow prevention apparatus to limit the rotation angle of the slat, so that the slat can keep the air outlet in the open state or the closed state. The specific shape and size of the first limit structure 5 and the second limit structure 6 may be designed as needed, which is not limited herein.

Accordingly, this embodiment further provides a backflow prevention apparatus, including a plurality of slats for backflow prevention described above.

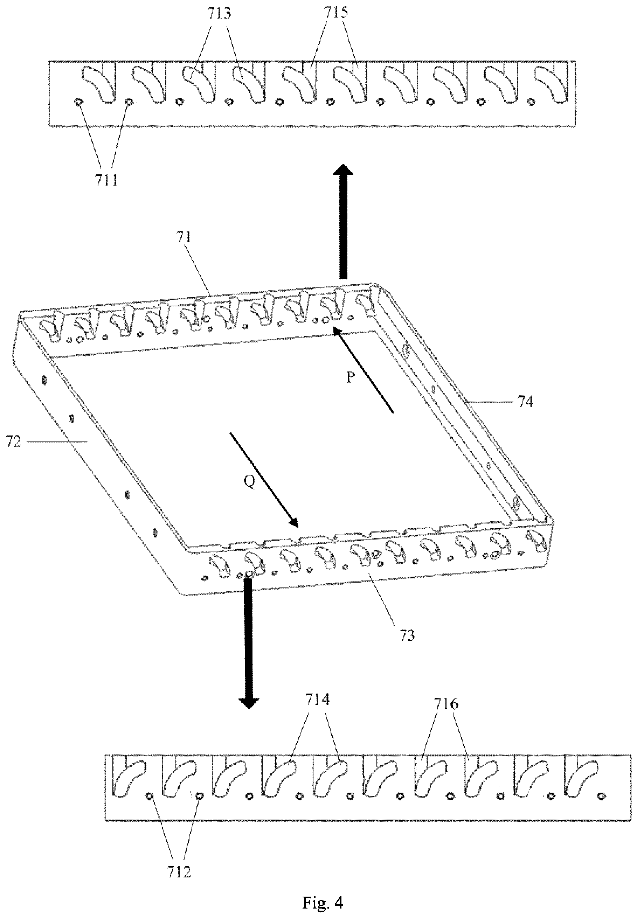

In an implementation, as shown in Fig. 4, in the above backflow prevention apparatus provided in this embodiment, the apparatus further includes an outer frame 7 to which a plurality of slats for backflow prevention as shown in Fig. 1 are connected.

The outer frame 7 may be of any shape including a plurality of side portions, and the specifics may be designed as needed, which is not limited herein. In this embodiment, an illustration will be provided taking the example in which the outer frame 7 includes four abutting side portions, and the four abutting side portions are a first side portion 71, a second side portion 72, a third side portion 73 and a fourth side portion 74, where the first side portion 71 of the outer frame 7 and the third side portion 73 of the outer frame 7 are provided opposite each other, and the second side portion 72 of the outer frame 7 and the fourth side portion 74 of the outer frame 7 are provided opposite each other.

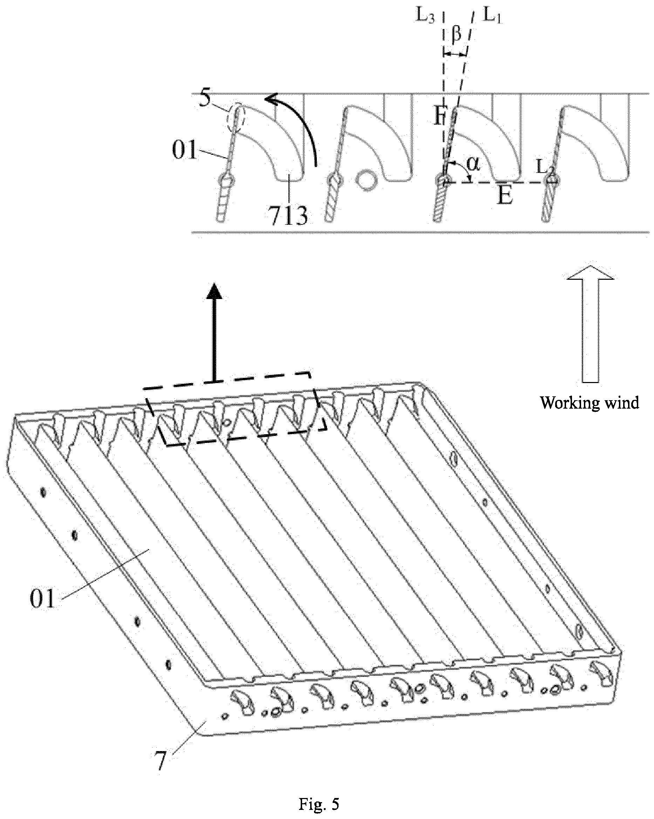

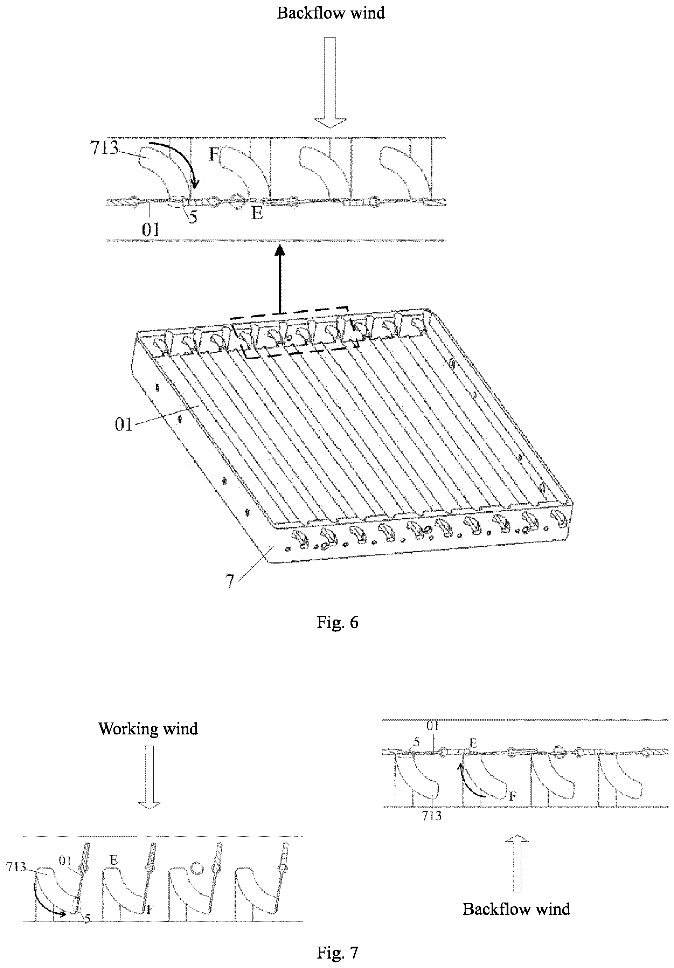

In an implementation, referring to Fig. 4, the upper part of Fig. 4 shows a front view of the first side portion 71 viewed from the P direction, and the lower part of Fig. 4 is a front view of the third side portion 73 viewed from the Q direction. Combined with Figs. 1 and 4, one end of the rotating shaft 2 is provided with a first rotating shaft head 3, and the first side portion 71 of the outer frame 7 is provided with a plurality of first connection portions 711, the first connection portions 711 having a one-to-one correspondence with the first rotating shaft heads 3. The other end of the rotating shaft 2 is provided with a second rotating shaft head 4, and the third side portion 73 of the outer frame 7 is provided with a plurality of second connection portions 712, the second connection portions 712 having a one-to-one correspondence with the second rotating shaft heads 4. The shape of the first connection portion 711 corresponds to the first rotating shaft head 3, and the first rotating shaft head 3 is connectable to the first connection portion 711, and the shape of the second connection portion 712 corresponds to the second rotating shaft head 4, and the second rotating shaft head 4 is connectable to the second connection portion 712, so as to connect a plurality of slats 01 to the outer frame 7 to form the louvered structure as shown in Figs. 5 and 6.

In an implementation, in the above backflow prevention apparatus provided in this embodiment, the first connection portion 711 and the second connection portion 712 may be, for example, through holes, half holes, recesses, etc., adapted to the first rotating shaft head 3 and the second rotating shaft head 4, and the specifics may be designed as needed, as long as the first rotating shaft head 3 can be snapped into the first connection portion 711 to be movably connected to the outer frame 7, and the second rotating shaft head 4 can be snapped into the second connection portion 712 to be movably connected to the outer frame 7, which is not limited herein. Fig 4 provides an illustration taking the example in which the first connection portion 711 and the second connection portion 712 are through holes.

In an implementation, in the above backflow prevention apparatus provided in this embodiment, the distances between adjacent first connection portions 711 are equal, that is, the first connection portions 711 are equally spaced on the first side portion 71 of the outer frame 7. The distances between adjacent second connection portions 712 are equal, that is, the second connection portions 712 are equally spaced on the second side portion 72 of the outer frame 7. Further, the distances between adjacent first connection portions 711 and the distances between adjacent second connection portions 712 are less than or equal to the width of the body 1 in the slat 01, so that the slats in the louvered structure, when in a horizontal position, can cover the air outlet and prevent the backflow wind from entering the interior of the device.

In an implementation, combined with Figs. 1 and 4, the first sub-slat 11 is provided with a first limit structure 5 at one end of the outer side of the first sub-slat 11 facing away from the rotating shaft 2, and the first side portion 71 of the outer frame 4 is provided with a plurality of first rotation grooves 713, the first rotation grooves 713 having a one-to-one correspondence with the first limit structures 5. The other end of the outer side of the first sub-slat 11 facing away from the rotating shaft 2 is provided with a second limit structure 6, and the third side portion 73 is provided with a plurality of second rotation grooves 714, the second rotation grooves 714 having a one-to-one correspondence with the second limit structures 6. After the slat 01 is connected to the outer shell 7, the first limit structure 5 on the first sub-slat 11 may be snapped into the first rotation groove 713 and the second limit structure 6 on the first sub-slat 11 may be snapped into the second rotation groove 714, and during the rotation of the slat 01 about the rotating shaft 2, the first limit structure 5 may slide in the first rotation groove 713 and the second limit structure 6 may slide in the second rotation groove 714, in order to limit the rotation range of the slat 01 to keep the louvered structure in an open or closed state.

As shown in Figs. 5 and 6, a partial view of the first rotation groove 713 is taken as an example for illustration in Figs. 5 and 6, and the wind direction of the working wind is from bottom to top, and the wind direction of the backflow wind is from top to bottom. The first rotation groove 713 has a groove wall at the first end and the second end, respectively, and the second rotation groove 714 has a groove wall at the first end and the second end, respectively.

As shown in Fig. 5, if the device operates normally and hot air (i.e., working wind) in the device is forced out from the air outlet, the slat 01 will rotate under the driving of the bottom-top working wind and the first limit structure 5 slides counterclockwise in the first rotation groove 713 until the first limit structure 5 abuts against the groove wall of the first end F of the first rotation groove 713, and the second limit structure 6 slides counterclockwise in the second rotation groove 714 until abutting against the groove wall of the first end of the second rotation groove 714, so as to limit the rotation amplitude of the slat 01 to cause the slat 01 to keep the air outlet in the open state, thus allowing the working wind to pass through. As can be seen from the above, in the slat provided in this embodiment, since the gravitational moment of the first sub-slat 11 may cancel out the gravitational moment of the second sub-slat 12, the resistance or assistance force generated by the self-weight of the slat 01 against the rotation of the slat 01 to the open state of the air outlet can be eliminated, so that the working wind can more easily and accurately drive the slat 01 to keep the air inlet in the open state during normal operation of the device, so that the device can dissipate heat normally.

As shown in Fig. 6, if the fan corresponding to a certain backflow prevention apparatus fails and stops rotation, resulting in backflow of the hot air forced out from the air outlet and forming a top-bottom backflow wind, the slat 01 rotates under the driving of the backflow wind, the first limit structure 5 slides clockwise in the first rotation groove 713 until the first limit structure 5 abuts against the groove wall of the second end E of the first rotation groove 713, and the second limit structure 6 slides clockwise in the second rotation groove 714 until abutting against the groove wall of the second end of the second rotation groove 714, so as to limit the rotation amplitude of the slat 01 to cause the slat to keep the air outlet in the closed state, thus blocking the working wind to pass through. As can be seen from the above, in the slat provided in this embodiment, since the gravitational moment of the first sub-slat 11 may cancel out the gravitational moment of the second sub-slat 12, the resistance or assistance force generated by the self-weight of the slat 01 against the rotation of the slat 01 to the closed state of the air inlet can be eliminated, so that if the heat dissipation system of the device fails and backflow wind is generated, the backflow wind can more easily and more accurately drive the slat 01 to keep the air inlet in the closed state, thus blocking the flow of backflow wind into the interior of the device to cause damage to the device.

It should be noted that the illustration has been provided above taking the application of the backflow prevention apparatus provided in this embodiment in the case in which the working wind flows from bottom to top as an example, and the backflow prevention apparatus provided in this embodiment can be applied to device in which the wind direction of the working wind and the backflow wind is in any direction, which is not limited herein.

For example, referring to Fig. 7, in the application of the backflow prevention apparatus provided in this embodiment in an air duct in which the working wind flows from top to bottom and the backflow wind flows from bottom to top, during the normal operation of the device, the working wind blows onto the slat 01 from top to bottom, causing the first limit structure 5 and the second limit structure 6 on the slat 01 to slide counterclockwise in the first rotation groove 713 and the second rotation groove 714, respectively. Since the working wind does not need to overcome gravity in this case, only a small working wind is needed to drive the slat 01 to rotate to keep the air outlet in the open state. Similarly, if the fan corresponding to a certain backflow prevention apparatus fails and stops rotation, the backflow wind blows onto the slat 01 from bottom to top and drives the slat 01 to rotate clockwise to close the air outlet, thus preventing the backflow wind from entering the device. Since the gravitational moment of the first sub-slat 11 may cancel out the gravitational moment of the second sub-slat 12, the resistance or assistance force generated by the self-weight of the slat 01 against the rotation of the slat 01 to the corresponding state can be eliminated, so that the working wind or backflow wind can more easily and accurately drive the slat 01 to keep the air inlet in the open or closed state.

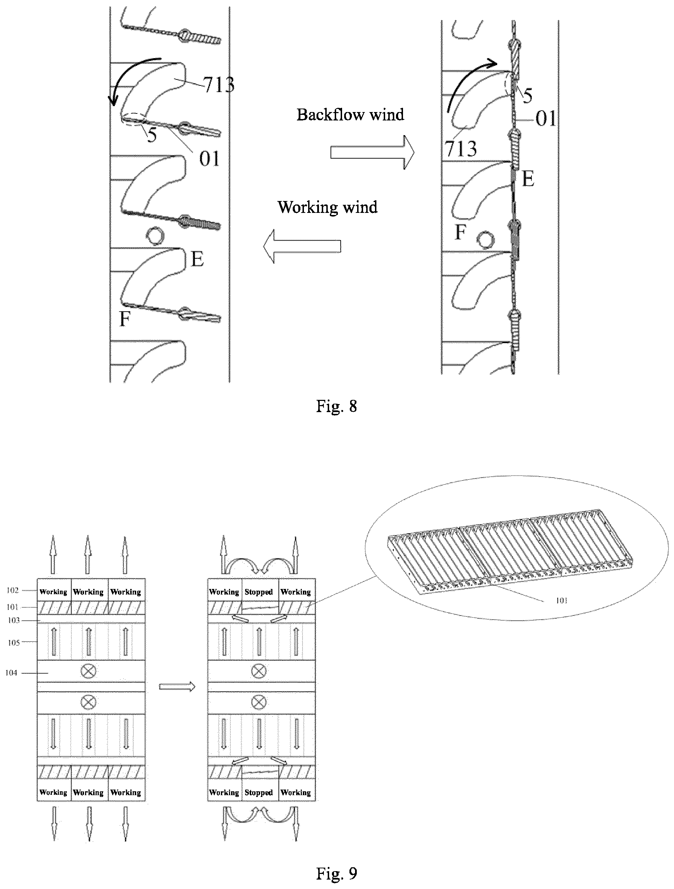

For another example, referring to Fig. 8, the backflow prevention apparatus provided in this embodiment is also applicable to device in which the wind direction is in the horizontal direction. An illustration will be provided taking the example of a device in which the working wind flows from right to left and the backflow wind flows from left to right. During normal operation of the device, the working wind blows from right to left onto the slat 01, causing the first limit structure 5 and the second limit structure 6 on the slat 01 to slide counterclockwise in the first rotation groove 713 and the second rotation groove 714, respectively. Similarly, if the fan corresponding to a certain backflow prevention apparatus fails and stops rotation, the backflow wind blows onto the slat 01 from left to right and drives the slat 01 to rotate clockwise to close the air outlet to prevent the backflow wind from entering the device. Since the gravitational moment of the first sub-slat 11 may cancel out the gravitational moment of the second sub-slat 12, the resistance or assistance force generated by the self-weight of the slat 01 against the rotation of the slat 01 to the corresponding state can be eliminated, so that the working wind or backflow wind can more easily and accurately drive the slat 01 to keep the air inlet in the open or closed state.

In an implementation, in the above backflow prevention apparatus provided in this embodiment, grooves of the first rotation groove 713 and the second rotation groove 714 are arcs, and curving directions of the arcs correspond to movement trajectories of the first limit structure 5 and the second limit structure 6 during the rotation of the body 1 of the slat 01 about the rotating shaft 2. During the rotation of the slat 01, the first limit structure 5 has no contact with the side groove wall of the first rotation groove 713, and the second limit structure 6 has no contact with the side groove wall of the second rotation groove 714, so the slat 01 does not generate friction with the first rotation groove 713 or the second rotation groove 714 during the rotation. Of course, the first rotation groove 713 and the second rotation groove 714 may also be of other shapes, and the specifics may be designed as needed, which is not limited herein.

In an implementation, as shown in Fig. 4, the first side portion 71 of the outer frame 7 is further provided with a plurality of first sliding grooves 715, where the first sliding grooves 715 correspond to the first limit structures 5, and one end of the first sliding groove 715 is in communication with the first rotation groove 713. The third side portion 73 of the outer frame 7 is further provided with a plurality of second sliding grooves 716, where the second sliding grooves 716 correspond to the second limit structures 6, and one end of the second sliding groove 716 is in communication with the second rotation groove 714 to make the first limit structure 5 slide into the first rotation groove 713 from the first sliding groove 715 and the second limit structure 6 slide into the second rotation groove 714 from the second sliding groove 716 when the slat 01 is to be installed on the outer frame 7, thus facilitating the installation of the slat 01.

In an implementation, as shown in Fig. 5, in the above backflow prevention apparatus provided in this embodiment, an angle α between an extension line L₁ of a first end F of the first rotation groove 713 and an extension line L₂ of a second end E of the first rotation groove 713 is less than 90°, and there is an inclination angle β between the extension line L₁ of the first end F of the first rotation groove 713 and a vertical direction L₃. Likewise, an angle between an extension line of a first end of the second rotation groove 714 and an extension line of a second end of the second rotation groove 714 is less than 90°, and there is an inclination angle between the extension line of the first end of the second rotation groove 714 and the vertical direction. If the backflow wind blows onto the slat 01 from the vertical direction L₃, since the wind direction of the backflow wind has a certain inclination angle with the angle of the slat 01 when rotating to the extension line L₁ (i.e., in the open state), the backflow wind can produce acting force on the slat 01, and thus the backflow wind can drive the slat to rotate.

Accordingly, this embodiment further provides an electronic device, including at least one backflow prevention apparatus described above. The electronic device may be any electronic device with a heat dissipation apparatus, such as a communication device, a server, a computer, etc., which is not limited herein.

In an implementation, as shown in Fig. 9, in the above electronic device provided in this embodiment, the electronic device includes a plurality of backflow prevention apparatuses 101 disposed side by side, and further includes an outer frame, a plurality of fans 102 disposed side by side, an air mixing unit 103, and an air inlet unit 104.

The air inlet unit 104 is provided within the outer frame and forces cold air into an interior 105 of the device by means of a motor, etc. The interior 105 of the device may be at a part or area of the device that generates high heat, and the air inlet unit 104 forces cold air into the interior 105 of the device to perform heat exchange, and the fan 102 is provided inside the outer frame to force hot air generated by the interior 105 of the device out of the interior 105 of the device. The backflow prevention apparatuses 101 are provided between the air mixing unit 103 and the fans 102 to open the air outlet under the driving of the working wind during normal operation of the device (the left side of Fig. 9) so that the hot air generated in the interior 105 of the device can be forced out from the air outlet, and to close the air outlet under the driving of the backflow wind when at least one of the fans 102 stops rotation (e.g., the middle fan 102 shown on the right side of Fig. 9 stops rotation) to prevent hot air forced out by the fans 102 from flowing back to the interior of the device. The mixing unit 103 is located between the air inlet unit 104 and the plurality of backflow prevention apparatuses 101, and the cold air flowing in from the air inlet unit 104 and the hot air generated in the interior 105 of the device meet and mix at the mixing unit 103, and the mixing unit is used to enable circulation of hot air generated in the interior 105 of the device, so that if a fan in the device stops rotation due to malfunction or human disassembly, etc., the hot air generated in the interior 105 of the device in the area corresponding to the stopped fan can be forced out of the interior 105 of the device by the other normally rotating fans 102 to avoid the situation where after a certain fan stops rotation the hot air generated in the interior 105 of the device in the area corresponding to the stopped fan cannot be forced out of the interior 105 of the device, which results in the accumulation of hot air at the stopped fan, thus improving the reliability of the heat dissipation function of the electronic device while saving space in the device compared to the way of adding a spare fan in the device interior, i.e., starting the spare fan to work when a fan stops rotation.

It should be noted that the electronic device provided in this embodiment may include air ducts in multiple directions and a combination of any number of fans and backflow prevention apparatuses. Fig. 9 provides an illustration taking the example in which the device has air ducts in two directions including an upper air duct and a lower air duct, and each air duct includes three fans and backflow prevention apparatuses. Here, there is no limit to the structure of the electronic device provided in this embodiment, and the specifics may be designed as needed.

In summary, with respect to the above slat for backflow prevention provided in the embodiments of the present disclosure, in the application of the slat in a backflow prevention apparatus, a plurality of such slats are installed in the backflow prevention apparatus, in which case the slats rotate to a corresponding position to control the air outlet to open so that the hot air (hereinafter referred to as "working wind") in the interior of the device can flow out from the air outlet, or the slats rotate to a corresponding position to control the air outlet to close so as to block the flow of backflow wind from the air outlet back to the interior of the device. Since the center-of-gravity region of the body 1 in the slat is on the rotating shaft 2, the position of the center of gravity g can be kept constant during the rotation of the slat about the rotating shaft 2, thus maintaining the stability of rotation. Further, since the magnitudes of the gravitational moments of the first sub-slat 11 and the second sub-slat 12 are approximately equal (or equal) while the extension direction of the first sub-slat 11 is opposite to that of the second sub-slat 12, that is, the gravitational moment of the first sub-slat 11 is in an opposite direction to the gravitational moment of the second sub-slat 12, during the rotation of the slat about the rotating shaft 2, under the premise that the center of gravity g of the slat is kept in a fixed position, the gravitational moment of the first sub-slat 11 can cancel out the gravitational moment of the second sub-slat, so that the slat can maintain self-balance. Therefore, it is possible to avoid the effect of the gravity of the slat during its rotation, thus causing the slat to rotate only under the driving of wind, and thus ensuring that the slat can accurately rotate to the position of opening or closing the air outlet in the corresponding situation.

In the above slat for backflow prevention provided in the embodiments of the present disclosure, since the center-of-gravity region of the slat is on the rotating shaft, the position of the center of gravity can be kept constant during the rotation of the slat about the rotating shaft, and since the magnitudes of the gravitational moments of the first sub-slat and the second sub-slat are approximately equal (or equal), the slat can maintain self-balance. Therefore, it is possible to avoid the effect of the gravity of the slat during its rotation, thus causing the slat to rotate only under the driving of wind, and thus ensuring that the slat can accurately rotate to the position of opening or closing the air outlet in the corresponding situation.

It can be understood that the above embodiments are only illustrative embodiments used to illustrate the principles of the present disclosure, and the present disclosure is not limited thereto. For those having ordinary skill in the art, various modifications and improvements can be made provided that these modifications and improvements fall within the scope of the amended claims.

## Claims

1. A slat for backflow prevention, comprising:
a body (1); and
a rotating shaft (2) connected to the body (1) and dividing the body (1) into a first sub-slat (11) and a second sub-slat (12) along a lengthwise direction of the body (1), wherein the rotating shaft (2) runs through the body (1) along the lengthwise direction of the body (1) and the first and second sub-slats (11, 12) are planar structures extending in directions facing away from the rotating shaft (2), the extension direction of the first sub-slat (11) being opposite to the extension direction of the second sub-slat (12);
wherein:
the body (1) is rotatable about the rotating shaft (2) and has a center of gravity (g) located on the rotating shaft (2), such that a difference between a magnitude of a gravitational moment of the first sub-slat (11) which is a product of a distance (d1) from a center of gravity (g1) of the first sub-slat (11) to the center of gravity (g) of the body (1) and the gravity (G1) on the first sub-slat (11) and a magnitude of a gravitational moment of the second sub-slat (12) which is a product of a distance (d2) from the center of gravity (g2) of the second sub-slat (12) to a center of gravity (g) of the body (1) and the gravity (G2) on the second sub-slat (12) does not exceed a preset value so that the slat can maintain self-balance during rotation;
an area of the first sub-slat (11) is greater than an area of the second sub-slat (12), and a mass of the first sub-slat (11) is less than or equal to a mass of the second sub-slat (12); and
a width of the first sub-slat (11) is greater than a width of the second sub-slat (12) in a direction perpendicular to the rotating shaft (2); and the first sub-slat (11) has a hollow interior.

2. The slat of claim 1, wherein
the center of gravity of the body (1) is located on the rotating shaft (2), and/or
the magnitude of the gravitational moment of the first sub-slat (11) is equal to the magnitude of the gravitational moment of the second sub-slat (12).

3. A backflow prevention apparatus (101), comprising a plurality of slats for backflow prevention of claim 1 or 2.

4. The backflow prevention apparatus (101) of claim 3, further comprising an outer frame (7) to which the plurality of slats are connected, wherein:
the outer frame (7) comprises a first side portion (71) and a third side portion (73) disposed opposite each other;
in each of the slats, the rotating shaft (2) is provided with a first rotating shaft head (3) and a second rotating shaft head (4) at two ends of the rotating shaft (2), respectively;
the first side portion (71) is provided with a plurality of first connection portions (711) having a one-to-one correspondence with the first rotating shaft heads (3); the third side portion (73) is provided with a plurality of second connection portions (712) having a one-to-one correspondence with the second rotating shaft heads (4); and the first rotating shaft head (3) is connectable to the first connection portion (711) and the second rotating shaft head (4) is connectable to the second connection portion (712) in order to connect the slat to the outer frame (7);
the first sub-slat (11) is provided with a first limit structure (5) and a second limit structure (6) at two ends of an outer side of the first sub-slat (11) facing away from the rotating shaft (2), respectively; and
the first side portion (71) is provided with a plurality of first rotation grooves (713) having a one-to-one correspondence with the first limit structures (5); the third side portion (73) is provided with a plurality of second rotation grooves (714) having a one-to-one correspondence with the second limit structures (6); and the first limit structure (5) slides in the first rotation groove (713) and the second limit structure (6) slides in the second rotation groove (714), during the rotation of the slat about the rotating shaft (2).

5. The backflow prevention apparatus (101) of claim 4, wherein:
distances between adjacent ones of the first connection portions (711) are equal; and distances between adjacent ones of the second connection portions (712) are equal; and
the distances between adjacent ones of the first connection portions (711) and the distances between adjacent ones of the second connection portions (712) are less than or equal to a width of the body (1).

6. The backflow prevention apparatus (101) of claim 4, wherein grooves of the first rotation groove (713) and the second rotation groove (714) are arcs, curving directions of the arcs corresponding to movement trajectories of the first limit structure (5) and the second limit structure (6) during the rotation of the slat about the rotating shaft (2).

7. The backflow prevention apparatus (101) of claim 4, wherein an angle between an extension line of a first end of the first rotation groove (713) and an extension line of a second end of the first rotation groove (713) is less than 90°, and the extension line of the first end of the first rotation groove (713) forms an inclination angle with a vertical direction; and
an angle between an extension line of a first end of the second rotation groove (714) and an extension line of a second end of the second rotation groove (714) is less than 90°, and the extension line of the first end of the second rotation groove (714) forms an inclination angle with the vertical direction.

8. An electronic device comprising at least one backflow prevention apparatus (101) of any one of claims 3 to 7.

9. The electronic device of claim 8, further comprising: an outer frame (7), a plurality of fans (102) disposed side by side, an air inlet unit (104), and an air mixing unit (103), wherein:
the air inlet unit (104) is disposed within the outer frame (7) to force cold air into an interior of the electronic device;
the fans (102) are disposed within the outer frame (7) to force hot air in the interior of the electronic device out of the interior of the electronic device;
the backflow prevention apparatus (101) is disposed between the air mixing unit (103) and the fans (102) to prevent hot air forced out by the fans (102) from flowing back into the interior of the electronic device when at least one fan stops rotation; and
the air mixing unit (103) is located between the air inlet unit (104) and the at least one backflow prevention apparatuses (101) to enable circulation of hot air in the interior of the electronic device.

## Patentansprüche

1. Lamelle zur Rückflussverhinderung, aufweisend:
einen Körper (1); und
eine rotierende Welle (2), die mit dem Körper (1) verbunden ist und den Körper (1) in eine erste Unterlamelle (11) und eine zweite Unterlamelle (12) entlang einer Längsrichtung des Körpers (1) unterteilt, wobei die rotierende Welle (2) durch den Körper (1) entlang der Längsrichtung des Körpers (1) verläuft und die ersten und die zweiten Unterlamellen (11, 12) planare Strukturen sind, die sich in von der rotierenden Welle (2) wegweisende Richtungen erstrecken, wobei die Erstreckungsrichtung der ersten Unterlamelle (11) der Erstreckungsrichtung der zweiten Unterlamelle (12) entgegengesetzt ist;
wobei:
der Körper (1) um die rotierende Welle (2) drehbar ist und einen Schwerpunkt (g) hat, der sich auf der rotierenden Welle (2) befindet, so dass eine Differenz zwischen einer Größe eines Gravitationsmoments der ersten Unterlamelle (11), das ein Produkt aus einem Abstand (d1) von einem Schwerpunkt (g1) der ersten Unterlamelle (11) zu dem Schwerpunkt (g) des Körpers (1) und der Schwerkraft (G1) auf der ersten Unterlamelle (11) ist, und einer Größe eines Gravitationsmoments der zweiten Unterlamelle (12), das ein Produkt aus einem Abstand (d2) von dem Schwerpunkt (g2) der zweiten Unterlamelle (12) zu einem Schwerpunkt (g) des Körpers (1) und der Schwerkraft (G2) auf der zweiten Unterlamelle (12) ist, einen vorbestimmten Wert nicht überschreitet, so dass die Lamelle während der Drehung ein Selbstgleichgewicht aufrechterhalten kann;
eine Fläche der ersten Unterlamelle (11) größer als eine Fläche der zweiten Unterlamelle (12) ist und eine Masse der ersten Unterlamelle (11) kleiner oder gleich einer Masse der zweiten Unterlamelle (12) ist; und
eine Breite der ersten Unterlamelle (11) größer als eine Breite der zweiten Unterlamelle (12) in einer Richtung senkrecht zu der rotierenden Welle (2) ist; und die erste Unterlamelle (11) einen hohlen Innenraum hat.

2. Lamelle nach Anspruch 1, wobei
sich der Schwerpunkt des Körpers (1) auf der rotierenden Welle (2) befindet, und/oder
die Größe des Gravitationsmoments der ersten Unterlamelle (11) gleich der Größe des Gravitationsmoments der zweiten Unterlamelle (12) ist.

3. Rückflussverhinderungsvorrichtung (101), aufweisend eine Vielzahl von Lamellen zur Rückflussverhinderung nach Anspruch 1 oder 2.

4. Rückflussverhinderungsvorrichtung (101) nach Anspruch 3, ferner aufweisend einen äußeren Rahmen (7), mit dem die Vielzahl von Lamellen verbunden sind, wobei:
der äußere Rahmen (7) einen ersten Seitenabschnitt (71) und einen dritten Seitenabschnitt (73) aufweist, die einander gegenüberliegend angeordnet sind;
in jeder der Lamellen die rotierende Welle (2) mit einem ersten rotierenden Wellenkopf (3) bzw. einem zweiten rotierenden Wellenkopf (4) an zwei Enden der rotierenden Welle (2) versehen ist;
der erste Seitenabschnitt (71) mit einer Vielzahl von ersten Verbindungsabschnitten (711) versehen ist, die eine Eins-zu-Eins-Entsprechung mit den ersten rotierenden Wellenköpfen (3) aufweisen; der dritte Seitenabschnitt (73) mit einer Vielzahl von zweiten Verbindungsabschnitten (712) versehen ist, die eine Eins-zu-Eins-Entsprechung mit den zweiten rotierenden Wellenköpfen (4) aufweisen; und der erste rotierende Wellenkopf (3) mit dem ersten Verbindungsabschnitt (711) verbindbar ist und der zweite rotierende Wellenkopf (4) mit dem zweiten Verbindungsabschnitt (712) verbindbar ist, um die Lamelle mit dem äußeren Rahmen (7) zu verbinden;
die erste Unterlamelle (11) mit jeweils einer ersten Begrenzungsstruktur (5) und einer zweiten Begrenzungsstruktur (6) an zwei Enden einer von der rotierenden Welle (2) wegweisenden Außenseite der ersten Unterlamelle (11) versehen ist; und
der erste Seitenabschnitt (71) mit einer Vielzahl von ersten Drehnuten (713) versehen ist, die eine Eins-zu-Eins-Entsprechung mit den ersten Begrenzungsstrukturen (5) aufweisen; der dritte Seitenabschnitt (73) mit einer Vielzahl von zweiten Drehnuten (714) versehen ist, die eine Eins-zu-Eins-Entsprechung mit den zweiten Begrenzungsstrukturen (6) aufweisen; und während der Drehung der Lamelle um die rotierende Welle (2) die erste Begrenzungsstruktur (5) in der ersten Drehnut (713) gleitet und die zweite Begrenzungsstruktur (6) in der zweiten Drehnut (714) gleitet.

5. Rückflussverhinderungsvorrichtung (101) nach Anspruch 4, wobei:
Abstände zwischen benachbarten der ersten Verbindungsabschnitte (711) gleich sind; und Abstände zwischen benachbarten der zweiten Verbindungsabschnitte (712) gleich sind; und
die Abstände zwischen benachbarten der ersten Verbindungsabschnitte (711) und die Abstände zwischen benachbarten der zweiten Verbindungsabschnitte (712) kleiner oder gleich einer Breite des Körpers (1) sind.

6. Rückflussverhinderungsvorrichtung (101) nach Anspruch 4, wobei Nuten der ersten Drehnut (713) und der zweiten Drehnut (714) Bögen sind, wobei Krümmungsrichtungen der Bögen Bewegungsbahnen der ersten Begrenzungsstruktur (5) und der zweiten Begrenzungsstruktur (6) während der Drehung der Lamelle um die rotierende Welle (2) entsprechen.

7. Rückflussverhinderungsvorrichtung (101) nach Anspruch 4, wobei ein Winkel zwischen einer Verlängerungslinie eines ersten Endes der ersten Drehnut (713) und einer Verlängerungslinie eines zweiten Endes der ersten Drehnut (713) kleiner als 90° ist und die Verlängerungslinie des ersten Endes der ersten Drehnut (713) einen Neigungswinkel mit einer vertikalen Richtung bildet; und
ein Winkel zwischen einer Verlängerungslinie eines ersten Endes der zweiten Drehnut (714) und einer Verlängerungslinie eines zweiten Endes der zweiten Drehnut (714) kleiner als 90° ist und die Verlängerungslinie des ersten Endes der zweiten Drehnut (714) einen Neigungswinkel mit der vertikalen Richtung bildet.

8. Elektronische Vorrichtung, aufweisend mindestens eine Rückflussverhinderungsvorrichtung (101) nach einem der Ansprüche 3 bis 7.

9. Elektronische Vorrichtung nach Anspruch 8, ferner aufweisend: einen äußeren Rahmen (7), eine Mehrzahl von nebeneinander angeordneten Lüftern (102), eine Lufteinlasseinheit (104) und eine Luftmischeinheit (103), wobei:
die Lufteinlasseinheit (104) innerhalb des äußeren Rahmens (7) angeordnet ist, um kalte Luft in einen Innenraum der elektronischen Vorrichtung zu fördern;
die Lüfter (102) innerhalb des äußeren Rahmens (7) angeordnet sind, um heiße Luft in dem Innenraum der elektronischen Vorrichtung aus dem Innenraum der elektronischen Vorrichtung heraus zu fördern;
die Rückflussverhinderungsvorrichtung (101) zwischen der Luftmischeinheit (103) und den Lüftern (102) angeordnet ist, um zu verhindern, dass von den Lüftern (102) herausgeförderte heiße Luft zurück in den Innenraum der elektronischen Vorrichtung strömt, wenn die Drehung mindestens eines Lüfters stoppt; und
die Luftmischeinheit (103) zwischen der Lufteinlasseinheit (104) und der mindestens einen Rückflussverhinderungsvorrichtung (101) angeordnet ist, um eine Zirkulation von heißer Luft in dem Innenraum der elektronischen Vorrichtung zu ermöglichen.

## Revendications

1. Lamelle pour prévention d'écoulement de retour, comprenant :
un corps (1) ; et
un arbre rotatif (2) raccordé au corps (1) et divisant le corps (1) en une première sous-lamelle (11) et une seconde sous-lamelle (12) le long d'une direction de longueur du corps (1), dans laquelle l'arbre rotatif (2) passe à travers le corps (1) le long de la direction de longueur du corps (1) et les première et seconde sous-lamelles (11, 12) sont des structures planes s'étendant dans des directions faisant face dans un sens opposé à l'arbre rotatif (2), la direction d'extension de la première sous-lamelle (11) étant opposée à la direction d'extension de la seconde sous-lamelle (12) ;
dans laquelle :
le corps (1) est rotatif autour de l'arbre rotatif (2) et a un centre de gravité (g) situé sur l'arbre rotatif (2), de manière telle qu'une différence entre une amplitude d'un moment gravitationnel de la première sous-lamelle (11) qui est un produit d'une distance (d1) depuis un centre de gravité (g1) de la première sous-lamelle (11) jusqu'au centre de gravité (g) du corps (1) et de la gravité (G1) sur la première sous-lamelle (11) et une amplitude d'un moment gravitationnel de la seconde sous-lamelle (12) qui est un produit d'une distance (d2) depuis le centre de gravité (g2) de la seconde sous-lamelle (12) jusqu'à un centre de gravité (g) du corps (1) et de la gravité (G2) sur la seconde sous-lamelle (12) ne dépasse pas une valeur prédéfinie de telle sorte que la lamelle peut maintenir un auto-équilibre durant la rotation ;
une superficie de la première sous-lamelle (11) est supérieure à une superficie de la seconde sous-lamelle (12), et une masse de la première sous-lamelle (11) est inférieure ou égale à une masse de la seconde sous-lamelle (12) ; et
une largeur de la première sous-lamelle (11) est supérieure à une largeur de la seconde sous-lamelle (12) dans une direction perpendiculaire à l'arbre rotatif (2) ; et la première sous-lamelle (11) a un intérieur creux.

2. Lamelle de la revendication 1, dans laquelle
le centre de gravité du corps (1) est situé sur l'arbre rotatif (2), et/ou
l'amplitude du moment gravitationnel de la première sous-lamelle (11) est égale à l'amplitude du moment gravitationnel de la seconde sous-lamelle (12).

3. Appareil de prévention d'écoulement de retour (101), comprenant une pluralité de lamelles pour prévention d'écoulement de retour de la revendication 1 ou 2.

4. Appareil de prévention d'écoulement de retour (101) de la revendication 3, comprenant en outre un cadre externe (7) auquel la pluralité de lamelles sont raccordées, dans lequel :
le cadre externe (7) comprend une première partie latérale (71) et une troisième partie latérale (73) disposée en face l'une de l'autre ;
dans chacune des lamelles, l'arbre rotatif (2) est pourvu d'une première tête d'arbre rotatif (3) et d'une seconde tête d'arbre rotatif (4) à deux extrémités de l'arbre rotatif (2), respectivement ;
la première partie latérale (71) est pourvue d'une pluralité de premières parties de raccordement (711) ayant une correspondance une-à-une avec les premières têtes d'arbre rotatif (3) ; la troisième partie latérale (73) est pourvue d'une pluralité de secondes parties de raccordement (712) ayant une correspondance une-à-une avec les secondes têtes d'arbre rotatif (4) ;
et la première tête d'arbre rotatif (3) peut être raccordée à la première partie de raccordement (711) et la seconde tête d'arbre rotatif (4) peut être raccordée à la seconde partie de raccordement (712) afin de raccorder la lamelle au cadre externe (7) ;
la première sous-lamelle (11) est pourvue d'une première structure limite (5) et d'une seconde structure limite (6) à deux extrémités d'un côté externe de la première sous-lamelle (11) faisant face dans un sens opposé à l'arbre rotatif (2), respectivement ; et
la première partie latérale (71) est pourvue d'une pluralité de premières rainures de rotation (713) ayant une correspondance une-à-une avec les premières structures limites (5) ; la troisième partie latérale (73) est pourvue d'une pluralité de secondes rainures de rotation (714) ayant une correspondance une-à-une avec les secondes structures limites (6) ; et la première structure limite (5) coulisse dans la première rainure de rotation (713) et la seconde structure limite (6) coulisse dans la seconde rainure de rotation (714), durant la rotation de la lamelle autour de l'arbre rotatif (2).

5. Appareil de prévention d'écoulement de retour (101) de la revendication 4, dans lequel :
des distances entre des parties adjacentes des premières parties de raccordement (711) sont égales ; et
des distances entre des parties adjacentes des secondes parties de raccordement (712) sont égales ; et
les distances entre des parties adjacentes des premières parties de raccordement (711) et les distances entre des parties adjacentes des secondes parties de raccordement (712) sont inférieures ou égales à une largeur du corps (1).

6. Appareil de prévention d'écoulement de retour (101) de la revendication 4, dans lequel des rainures de la première rainure de rotation (713) et de la seconde rainure de rotation (714) sont des arcs, des directions de courbure des arcs correspondant à des trajectoires de mouvement de la première structure limite (5) et de la seconde structure limite (6) durant la rotation de la lamelle autour de l'arbre rotatif (2).

7. Appareil de prévention d'écoulement de retour (101) de la revendication 4, dans lequel un angle entre une ligne d'extension d'une première extrémité de la première rainure de rotation (713) et une ligne d'extension d'une seconde extrémité de la première rainure de rotation (713) est inférieur à 90°, et la ligne d'extension de la première extrémité de la première rainure de rotation (713) forme un angle d'inclinaison avec une direction verticale ; et
un angle entre une ligne d'extension d'une première extrémité de la seconde rainure de rotation (714) et une ligne d'extension d'une seconde extrémité de la seconde rainure de rotation (714) est inférieur à 90°, et la ligne d'extension de la première extrémité de la seconde rainure de rotation (714) forme un angle d'inclinaison avec la direction verticale.

8. Dispositif électronique comprenant au moins un appareil de prévention d'écoulement de retour (101) de l'une quelconque des revendications 3 à 7.

9. Dispositif électronique de la revendication 8, comprenant en outre : un cadre externe (7), une pluralité de ventilateurs (102) disposés côte à côte, une unité d'entrée d'air (104), et une unité de mélangeage d'air (103), dans lequel :
l'unité d'entrée d'air (104) est disposée au-dedans du cadre externe (7) pour forcer de l'air froid dans un intérieur du dispositif électronique ;
les ventilateurs (102) sont disposés au-dedans du cadre externe (7) pour forcer de l'air chaud à l'intérieur du dispositif électronique hors de l'intérieur du dispositif électronique ;
l'appareil de prévention d'écoulement de retour (101) est disposé entre l'unité de mélangeage d'air (103) et les ventilateurs (102) pour empêcher de l'air chaud forcé en dehors par les ventilateurs (102) de s'écouler en retour dans l'intérieur du dispositif électronique lorsqu'au moins un ventilateur arrête la rotation ; et
l'unité de mélangeage d'air (103) est située entre l'unité d'entrée d'air (104) et l'au moins un appareil de prévention d'écoulement de retour (101) pour permettre la circulation d'air chaud à l'intérieur du dispositif électronique.
